# EUROPEAN PATENT APPLICATION

(11) **EP 4 847 580 A1**
(43) Date of publication of application: **02.12.2026**
(21) Application number: 26181516.1
(22) Date of filing: 28.05.2026
(51) Int. Cl.: C09K 5/06, H10W 40/25, H10W 40/73, H10W 42/20

(54) **THERMAL INTERFACE MATERIALS WITH LOW TEMPERATURE AND LOW PRESSURE BURN-IN AND PUMPOUT RESISTANCE**

(30) Priority: 30.05.2025 US 202563815211 P
(71) Applicant: Laird Technologies, Inc., Chesterfield, MO 63017 (US)
(72) Inventor: PATTERSON, Anastasia, Chesterfield, Missouri, 63017 (US)
(74) Representative: Lind Edlund Kenamets Intellectual Property AB

(57) **Abstract**

The present disclosure relates to thermal interface materials configured to have low temperature and low pressure burn-in and resistance to pumpout. In exemplary embodiments, a phase change thermal interface material is configured to have resistance to pumpout and a low temperature and low pressure burn-in, which enables the phase change thermal interface material to soften and deflect to its thinnest bond line and/or minimum thermal resistance at a minimal temperature of about 50 degrees Celsius (°C) or less while under a minimal pressure of 16 pounds per square inch (PSI) or less.

## Description

### FIELD

The present disclosure relates to thermal interface materials configured to have low temperature and low pressure burn-in and pumpout resistance.

### BACKGROUND

This section provides background information related to the present disclosure which is not necessarily prior art.

Electrical components, such as semiconductors, integrated circuit packages, transistors, *etc.,* typically have pre-designed temperatures at which the electrical components optimally operate. Ideally, the pre-designed temperatures approximate the temperature of the surrounding air. But the operation of electrical components generates heat. If the heat is not removed, the electrical components may then operate at temperatures significantly higher than their normal or desirable operating temperature. Such excessive temperatures may adversely affect the operating characteristics of the electrical components and the operation of the associated device.

To avoid or at least reduce the adverse operating characteristics from the heat generation, the heat should be removed, for example, by conducting the heat from the operating electrical component to a heat sink. The heat sink may then be cooled by conventional convection and/or radiation techniques. During conduction, the heat may pass from the operating electrical component to the heat sink either by direct surface contact between the electrical component and heat sink and/or by contact of the electrical component and heat sink surfaces through an intermediate medium or thermal interface material (TIM). The thermal interface material may be used to fill the gap between thermal transfer surfaces, in order to increase thermal transfer efficiency as compared to having the gap filled with air, which is a relatively poor thermal conductor.

In addition, a common problem in the operation of electronic devices is the generation of electromagnetic radiation within the electronic circuitry of the equipment. Such radiation may result in electromagnetic interference (EMI) or radio frequency interference (RFI), which can interfere with the operation of other electronic devices within a certain proximity. Without adequate shielding, EMI/RFI interference may cause degradation or complete loss of important signals, thereby rendering the electronic equipment inefficient or inoperable.

The term "EMI" as used herein should be considered to generally include and refer to EMI emissions and RFI emissions, and the term "electromagnetic" should be considered to generally include and refer to electromagnetic and radio frequency from external sources and internal sources. Accordingly, the term shielding (as used herein) broadly includes and refers to mitigating (or limiting) EMI and/or RFI, such as by absorbing, reflecting, blocking, and/or redirecting the energy or some combination thereof so that it no longer interferes, for example, for government compliance and/or for internal functionality of the electronic component system.

### DRAWINGS

The drawings described herein are for illustrative purposes only of selected embodiments and not all possible implementations, and are not intended to limit the scope of the present disclosure.
FIG. 1 is a line graph of the temperature delta/difference (°C) versus heat sink temperature (°C) across a conventional thermal phase change material (labeled A) and thermal phase change material (labeled B) according to an exemplary embodiment of the present disclosure.
FIG. 2 includes a table of exemplary properties for a thermal phase change material according to an exemplary embodiment of the present disclosure.

### DETAILED DESCRIPTION

Exemplary embodiments were developed and/or are disclosed herein of thermal interface materials (broadly, materials) configured to have low temperature and low pressure burn-in and resistance to pumpout. In exemplary embodiments, a thermal interface material (e.g., thermal phase change material, *etc.)* is configured to have resistance to pumpout and a low temperature and low pressure burn-in, which enables the thermal interface material to soften and deflect to its thinnest bond line and/or minimum thermal resistance at a minimal temperature of about 50 degrees Celsius (°C) or less while under a minimal pressure of 16 pounds per square inch (PSI) or less. In such exemplary embodiments, additional temperature/pressure does not further decrease the thermal resistance of the thermal interface material after the thermal interface material has softened and deflected to its thinnest bond line and/or minimum thermal resistance at the minimal temperature of about 50 degrees Celsius (°C) or less while under the minimal pressure of 16 pounds per square inch (PSI) or less.

With its low temperature and low pressure burn-in, the thermal interface material may be heated to its minimal burn-in temperature during an initial operation of an electronic. The thermal interface material may then soften and deflect to its thinnest bond line and/or minimum thermal resistance between a heat dissipating/removal structure and the heat source of the electronic device to thereby establish a thermal joint for conducting heat between the heat dissipating/removal structure and the heat source. After which, the thermal interface material may return to its original state and remain in its original state (*e.g.,* a resistant-to-flow state, *etc*.) after forming its thinnest bond line and/or minimum thermal resistance between the heat source and the heat dissipating/removal structure. At which point, the thermal interface material precludes the heat source from heating beyond its normal operating temperature range during operation of the electronic device and heat is flowable through the thermal joint from the heat source during operation of the electronic device whereby temperature of the heat source is reduced.

In addition to their advantageous low temperature and low pressure burn-in, the exemplary thermal interface materials disclosed herein are also configured to have resistance to pumpout, which may thus provide better and/or improved thermal reliability. In exemplary embodiments, the thermal interface material will remain in place (*e.g.,* not migrate, bleed, pump out, creep out, *etc*.) during thermal cycling and/or during thermal reliability testing, *e.g*., power cycling setup including a die size and warpage, temperature range from about 25 °C to about 80 °C, 1-hour cycles, 2000 cycles total, with void% less than about 3% (*e.g.,* void% within a range from about 1% to about 3%, *etc*.). Other suitable tests can also be used that impart a cycling warpage and temperature relevant to the application. And the performance metric can be voiding (*e.g.,* by image analysis, acoustic microscopy, *etc.*) or by measuring the thermal resistance across the thermal interface material.

The exemplary thermal materials disclosed herein may also be configured to have one or more advantageous properties such as elongation to break, adhesion, shear thinning/thixotropic index, *etc.* The thermal interface materials (TIMs) may comprise thermal phase change materials, EMI absorber materials, thermally-conductive EMI absorber materials, electrically-conductive materials, combinations thereof, *etc.*

In exemplary embodiments, a thermal interface material is provided comprising a thermally conductive phase change material configured to enhance heat transfer between a heat-generating component and a heat dissipation structure. The material exhibits a bulk thermal conductivity on the order of at least about 7 W/m·K, and in certain embodiments approximately 7.5 W/m·K, thereby enabling effective heat dissipation in high-performance electronic systems. The phase change material is formulated to reduce interfacial thermal resistance by conforming to mating surfaces and displacing interstitial air gaps during operation.

In some embodiments, the material comprises a filled thermoplastic, non-silicone-based polymeric matrix that transitions at an elevated temperature to improve surface wetting and interfacial contact. The composition can be configured to exhibit inherent tackiness sufficient to maintain placement during handling and assembly, while remaining readily removable for manufacturing processes. The polymeric matrix further provides enhanced resistance to "pump-out" effects under thermal cycling conditions when compared to conventional thermal greases and alternative phase change formulations.

The phase change material may be implemented as a free-standing sheet or preformed structure having a thickness selected according to application requirements, for example in a range of about 0.1 mm to about 0.4 mm. In certain embodiments, the material can achieve a minimum bondline thickness on the order of tens of microns, such as approximately 25 µm, after activation of the phase change state under applied pressure and temperature. The resulting interface provides a low thermal resistance pathway, for example, less than about 0.1 °C·cm²/W under moderate pressure conditions.

The material demonstrates reliable operation across a wide temperature range, for example from approximately -40°C to about 125°C, making it suitable for demanding environments including computing systems, power electronics, and automotive applications. Long-term stability may be demonstrated through extended thermal aging or environmental exposure testing, with performance maintained after prolonged operation at elevated temperatures.

In certain use cases, the phase change material undergoes a controlled softening or transition during an initial burn-in or activation process at elevated temperature and pressure, thereby improving conformability and reducing interfacial resistance. Following this transition, the material forms a stable thermal interface exhibiting consistent heat transfer characteristics over repeated thermal cycles.

Additional embodiments may provide an electrically insulating material having high volume resistivity, for example greater than about 10^15 ohm-cm, while maintaining thermally conductive properties. The material may also meet flammability or safety standards, such as a V-0 rating, and can be formulated to comply with environmental and regulatory requirements.

The thermal phase change material can be provided in various formats, including sheets, die-cut components, or roll-based forms, optionally incorporating handling features such as tabs or liners to facilitate automated or manual placement. Such materials are particularly suited for use in electronic assemblies including processors, graphics modules, memory devices, power semiconductor devices, and other heat-generating components requiring efficient thermal management.

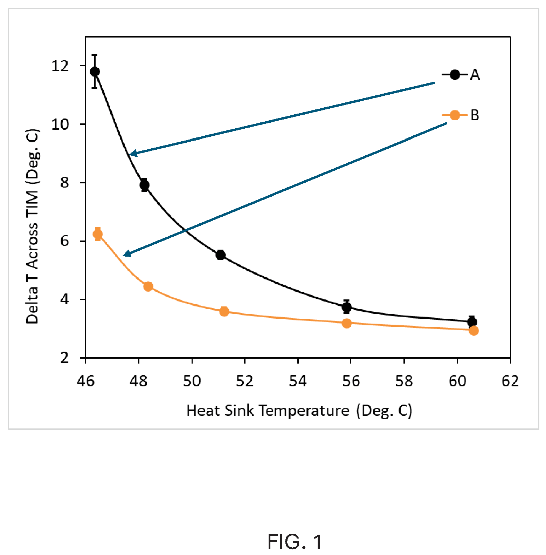

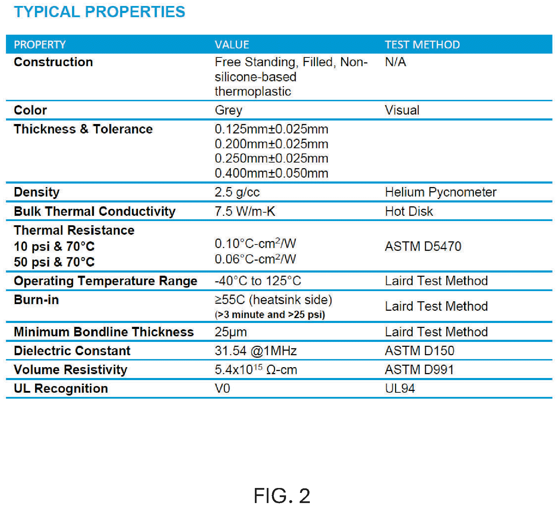

By way of example, FIG. 1 is a line graph of the temperature delta/difference (°C) versus heat sink temperature (°C) across a conventional thermal phase change material (labeled A) and thermal phase change material (labeled B) according to an exemplary embodiment of the present disclosure. FIG. 2 includes a table of exemplary properties for a thermal phase change material according to an exemplary embodiment of the present disclosure.

Disclosed are exemplary embodiments are materials (e.g., thermal interface materials (TIMs), *etc.)* useful for the management of heat and/or electromagnetic interference (EMI). The material comprises at least one filler in a matrix. The material is configured to have a low temperature and low pressure burn-in that enables the material to soften and deflect to its thinnest bond line and/or minimum thermal resistance at a minimal temperature of about 50 degrees Celsius (°C) or less while under a minimal pressure of 16 pounds per square inch (PSI) or less.

In exemplary embodiments, the material is configured to soften and deflect to its thinnest bond line and/or minimum thermal resistance when heated to the minimal temperature of about 50 °C or less while under a minimal pressure from about 5 PSI to 10 PSI.

In exemplary embodiments, the material is configured to soften and deflect to its thinnest bond line of about 25 microns when heated to the minimal temperature of about 50 °C or less while under the minimal pressure of 16 PSI or less.

In exemplary embodiments, the material is configured to soften and deflect from an initial thickness within a range from about 125 microns to 400 microns (*e.g*., 0.125 mm, 0.2 mm, 0.25 mm, 0.4 mm, *etc*.) down to a bond line thickness of about 25 microns when the material is heated to the minimal temperature of about 50 °C or less while under the minimal pressure of 16 PSI or less.

In exemplary embodiments, the material comprises at least one filler in a matrix including di-block copolymer and processing oil. The material may be entirely free of tri-block copolymer and/or the material may not include any detectable tri-block copolymer. In exemplary embodiments, the matrix comprises a thermally reversible gel that is entirely free of tri-block copolymer and/or that does not include any detectable tri-block copolymer. The thermal interface material may be configured to be thermally reversible and/or self-healing without undergoing an order-disorder transition.

In exemplary embodiments, the material is configured to have an inverse tan delta of at least 1.75 within a temperature range from about 25 °C to about 150 °C.

In exemplary embodiments, the material has a hardness of about 93 Shore 00 or less at room temperature or a temperature of about 25 °C. For example, the material may have a hardness within a range from about 86 Shore 00 to about 93 Shore 00 at room temperature or a temperature of about 25 °C.

In exemplary embodiments, the material is entirely free of silicone and/or the material does not include any detectable silicone. And the material is usable with no occurrence of silicone migration or volatility due to the absence of silicone in the formulation.

In exemplary embodiments, the material is a thermal phase change material that is configured to have a better/higher resistance to pumpout than conventional thermal phase change materials, conventional thermal greases, and conventional dispensable thermal interface materials.

In exemplary embodiments, the material comprises a thermal phase change material configured such that an initial operation of the heat source within its normal operating temperature range heats the thermal phase change material to the minimal temperature of about 50 °C or less while under the minimal pressure of 16 PSI or less whereby the thermal phase change material softens and deflects to its thinnest bond line and/or minimum thermal resistance between the heat dissipating/removal structure and the heat source to thereby establish the thermal joint for conducting heat between the heat dissipating/removal structure and the heat source. And the thermal phase change material is configured to return to its original state and remain in its original state after forming the thinnest bond line and/or minimum thermal resistance between the heat source and the heat dissipating/removal structure, whereby the thermal phase change material is operable to preclude the heat source from heating beyond its normal operating temperature range during operation of the electronic device and heat is flowable through the thermal joint from the heat source during operation of the electronic device whereby temperature of the heat source is reduced.

In exemplary embodiments, the thermal interface material has a high thermal conductivity (e.g., within a range from about 7 Watts per meter per Kelvin (W/mK) to about 9 W/mK, *etc.)* as determined by Hot Disk Thermal Constants Analyzer. For example, the thermal interface material may have a thermal conductivity of 7, 7.5, 8, 8.5, or 9 W/mK as determined by Hot Disk Thermal Constants Analyzer. To determine thermal conductivity, a Hot Disk instrument may be used that measures thermal conductivity, thermal diffusivity, and specific heat capacity using the Transient Plane Source Method. By way of background, this technique is covered under the ISO 22007-2:2008; Part 2 Standard. The technique utilizes a plane sensor and a special mathematical model that describes the heat conductivity, combined with electronics that enables the method to be used to measure Thermal Transport Properties. It covers a thermal conductivity range of typically 0.01-500 W/m/K. The Transient Plane Source technique typically employs two samples halves sandwiching the sensor. This method can also be used in a single-sided configuration. The technique is versatile and fast, covering measurements of solids, pastes, thin films and liquids. The technique can test both isotropic and anisotropic material. The flat sensor includes a continuous double spiral of electrically conducting nickel metal, etched out of a thin foil. The nickel spiral is situated between two layers of thin polyimide film Kapton. During the measurement, a constant electrical effect is passed through the conducting spiral, increasing the sensor temperature. The heat generated dissipates into the sample on both sides of the sensor, at a rate depending on the thermal transport properties of the material. By recording temperature versus time response in the sensor, the thermal conductivity, thermal diffusivity, and specific heat capacity of the material can be calculated.

In exemplary embodiments, a device or system comprises a material disclosed herein that is used for managing thermal properties of the device or system. The material is configured such that an initial operation of the device or system heats the material to the minimal temperature of about 50 °C or less while under the minimal pressure of 16 PSI or less. In such exemplary embodiments, the material is configured to soften during the initial device operation to conform to surface irregularities and subsequently stabilizes to provide a consistent thermal interface across repeated thermal cycles without material displacement.

In exemplary embodiments, the material is a thermal interface material, an EMI absorber material, a thermally-conductive absorber material, an electrically-conductive material, or a combination of two or more thereof.

In exemplary embodiments, the material is a thermal phase change material that is configured to have a better/higher resistance to pumpout than conventional thermal phase change materials, conventional thermal greases, and conventional dispensable thermal interface materials.

In exemplary embodiments, the thermal interface material comprises a matrix and one or more fillers in the matrix. In some exemplary embodiments, the matrix includes processing oil and a thermoplastic thickener, such as di-block copolymer, *etc.* The matrix may comprise a thermoplastic resin system including the processing oil and the thermoplastic thickener and/or a silicone free resin system including the processing oil and the thermoplastic thickener. In some exemplary embodiments, the thermal interface material includes di-block copolymer but the thermal interface material is entirely free of tri-block copolymer and/or does not include any detectable tri-block copolymer.

In exemplary embodiments, the one or more fillers in the matrix comprise one or more fillers that comprise one or more of: thermally-conductive filler(s); electrically-conductive filler(s); electromagnetic wave absorbing filler(s); dielectric filler(s); and filler(s) that has two or more properties of being thermally conductive, electrically conductive, dielectric, and electromagnetic wave absorbing. The one or more fillers (e.g., ranging in size from 0.1 µm to 250 µm (D50), spherical shape, round shape, *etc.)* may comprise one or more of alumina, zinc oxide, boron nitride, silicon nitride, aluminum, aluminum nitride, diamond, aluminum metal powder, iron, metallic oxides, graphite, silicon carbide, ceramic, alumina, zinc oxide, carbonyl iron, silver, aluminum nitride, barium titanate, other thermally-conductive and/or EMI absorbing fillers, combinations thereof, *etc.* In an exemplary embodiment, the TIM includes a thermally-conductive filler consisting only of alumina. In another exemplary embodiment, the TIM includes aluminum nitride filler and alumina filler. In exemplary embodiments, the TIM may also include one or more other additives, such as antioxidant, metal deactivator, and/or dispersant, *etc.* In some exemplary embodiments, the material is a thermal interface material, an EMI absorber material, a thermally-conductive EMI absorber material, an electrically-conductive material, or a combination of two or more thereof.

In exemplary embodiments, the material is a thermal phase change material that is configured to have a better/higher resistance to pumpout than conventional thermal phase change materials, conventional thermal greases, and conventional dispensable thermal interface materials.

In exemplary embodiments, the material includes thermally-conductive filler and EMI absorbing filler such that the material comprises a multifunctional EMI absorber having a first functionality of EMI mitigation and a second functionality of thermal management, or vice versa. By way of example, the fillers may comprise one or more of functional nanoparticles, electrically-conductive fillers, thermally-conductive fillers, EMI or microwave absorbing fillers, magnetic fillers, coated fillers, combinations thereof, *etc.* The fillers may be added and mixed into a bulk material including the matrix material to thereby provide a mixture of the filler and base or matrix material. Example fillers include carbon black, boron nitride, nickel cobalt, carbonyl iron, iron silicide, iron particles, iron-chrome compounds, silver, an alloy containing 85% iron, 9.5% silicon and 5.5% aluminum, an alloy containing about 20% iron and 80% nickel, ferrites, magnetic alloys, magnetic powders, magnetic flakes, magnetic particles, nickel-based alloys and powders, chrome alloys, oxide, copper, zinc oxide, alumina, graphite, ceramics, silicon carbide, manganese zinc, fiberglass, carbon nanotubes (e.g., single-walled carbon nanotubes, multi-walled carbon nanotubes, and/or carbon nanostructures, *etc.),* combinations thereof, *etc.* The fillers may comprise one or more of granules, spheroids, microspheres, ellipsoids, irregular spheroids, strands, flakes, powder, nanotubes, and/or a combination of any or all of these shapes. In addition, exemplary embodiments may also include different grades (e.g., different sizes, different purities, different shapes, *etc.)* of the same (or different) fillers.

In exemplary embodiments, the material comprises a solid, free-standing phase change composition including a thermally conductive filler dispersed within a non-silicone polymeric matrix. The composition is configured to: transition from a first, dimensionally stable state to a softened conformable state in response to elevated temperature; wet opposing surfaces of a heat-generating component and a heat dissipation structure during the softened state to displace interfacial air; and re-establish a mechanically stable interface upon cooling. The material provides a thermally conductive pathway and resists migration or pump-out under thermal cycling. The material transitions to the softened conformable state without exhibiting bulk flow and re-solidifies to maintain positional stability and resist pump-out in the absence of a containment structure.

In exemplary embodiments, the material complies with flammability standards corresponding to a V0 UL94 rating. The material is configured to remain substantially in place between mating surfaces without migration during thermal cycling thereby substantially preventing at least one of pump-out, bleed, creep, or lateral displacement of the material. For example, the material may be configured to exhibit less than about 3% interfacial voiding following repeated power cycling between a lower temperature of about 25°C and an upper temperature of about 80°C with cycle durations of approximately one hour and at least about 2,000 cycles.

Also disclosed are exemplary methods for establishing a thermal joint for conducting heat between a heat dissipating/removal structure and a heat source of an electronic device. In exemplary embodiments, the method comprises positioning a thermal interface material between the heat dissipating/removal structure and the heat source. The thermal interface material is configured to have a low temperature and low pressure burn-in that enables the thermal interface material to soften and deflect to its thinnest bond line and/or minimum thermal resistance at a minimal temperature of about 50 degrees Celsius (°C) or less while under a minimal pressure of 16 pounds per square inch (PSI) or less. Additionally, or alternatively, the method may comprise heating a thermal interface material to a minimal temperature of about 50 (°C) or less while under a minimal pressure of 16 pounds per square inch (PSI) or less such that the thermal interface material softens and is deflectable to its thinnest bond line and/or minimum thermal resistance between the heat dissipating/removal structure and the heat source of the electronic device.

In exemplary embodiments, the method includes heating the thermal interface material to the minimal temperature of about 50 °C or less while under the minimal pressure of 16 pounds per square inch (PSI) or less such that the thermal interface material softens and deflects to its minimum thermal resistance whereby additional heating/pressure will not further decrease the thermal resistance of the thermal interface material.

In exemplary embodiments, the method includes heating the thermal interface material to the minimal temperature of about 50 °C or less while under a minimal pressure from about 5 PSI to 10 PSI.

In exemplary embodiments, the method includes heating the thermal interface material to the minimal temperature of about 50 °C or less while under the minimal pressure of 16 PSI or less such that the thermal interface material softens and deflects to its thinnest bond line of about 25 microns between the heat dissipating/removal structure and the heat source of the electronic device.

In exemplary embodiments, the method include heating the thermal interface material to the minimal temperature of about 50 °C or less while under the minimal pressure of 16 PSI such that the thermal interface material softens and deflects from an initial thickness within a range from about 125 microns to 400 microns *(e.g.,* 0.125 mm, 0.2 mm, 0.25 mm, 0.4 mm, *etc.)* down to a bond line thickness of about 25 microns between the heat dissipating/removal structure and the heat source of the electronic device.

In exemplary methods, the thermal interface material comprises at least one filler in a matrix including di-block copolymer and processing oil. The thermal interface material may be entirely free of tri-block copolymer and/or the thermal interface material may not include any detectable tri-block copolymer. In exemplary methods, the matrix comprises a thermally reversible gel that is entirely free of tri-block copolymer and/or that does not include any detectable tri-block copolymer. The thermal interface material may be configured to be thermally reversible and/or self-healing without undergoing an order-disorder transition.

In exemplary methods, the thermal interface material is configured to have an inverse tan delta of at least 1.75 within a temperature range from about 25 °C to about 150 °C.

In exemplary embodiments, the method includes operating the electronic device to thereby heat the thermal interface material to the minimal temperature of about 50 °C or less while under the minimal pressure of 16 PSI or less between the heat dissipating/removal structure and the heat source of the electronic device.

In exemplary methods, the thermal interface material has a thermal conductivity within a range from about 7 Watts per meter per Kelvin (W/mK) to about 9 W/mK as determined by Hot Disk Thermal Constants Analyzer.

In exemplary methods, wherein the thermal interface material has a hardness of about 93 Shore 00 or less at room temperature or a temperature of about 25 °C. For example, the thermal interface material may have a hardness within a range from about 86 Shore 00 to about 93 Shore 00 at room temperature or a temperature of about 25 °C.

In exemplary methods, the thermal interface material is entirely free of silicone and/or the thermal interface material does not include any detectable silicone. And the thermal interface material is usable with no occurrence of silicone migration or volatility due to the absence of silicone in the formulation.

In exemplary methods, the thermal interface material is a thermal phase change material that is configured to have a better/higher resistance to pumpout than conventional thermal phase change materials, conventional thermal greases, and conventional dispensable thermal interface materials.

In exemplary methods, the thermal interface material comprises a thermal phase change material configured such that an initial operation of the heat source within its normal operating temperature range heats the thermal phase change material to the minimal temperature of about 50 °C or less while under the minimal pressure of 16 PSI or less whereby the thermal phase change material softens and deflects to its thinnest bond line and/or minimum thermal resistance between the heat dissipating/removal structure and the heat source to thereby establish the thermal joint for conducting heat between the heat dissipating/removal structure and the heat source. And the thermal phase change material is configured to return to its original state and remain in its original state after forming the thinnest bond line and/or minimum thermal resistance between the heat source and the heat dissipating/removal structure, whereby the thermal phase change material is operable to preclude the heat source from heating beyond its normal operating temperature range during operation of the electronic device and heat is flowable through the thermal joint from the heat source during operation of the electronic device whereby temperature of the heat source is reduced.

In exemplary methods, the method includes adding one or more fillers to the material. The one or more fillers may comprise one or more of: thermally-conductive filler(s); electrically-conductive filler(s); electromagnetic wave absorbing filler(s); dielectric filler(s); and filler(s) that has two or more properties of being thermally conductive, electrically conductive, dielectric, and electromagnetic wave absorbing. The one or more fillers may comprise one or more of alumina, zinc oxide, boron nitride, silicon nitride, aluminum, aluminum nitride, diamond, aluminum metal powder, iron, metallic oxides, graphite, silicon carbide, and ceramic.

In exemplary methods, the thermal interface material is a thermal phase change material, And the method includes applying heat and pressure to the thermal phase change material to induce a phase change and causing the thermal phase change material to conform to opposing surfaces and reduce interfacial thermal resistance. The heat and pressure comprise a burn-in process sufficient to soften the thermal phase change material and improve wetting. And the thermal phase change material forms a bondline thickness of less than about 50 microns after the phase change.

In exemplary methods, the method includes positioning a solid phase change thermal interface material between the heat dissipating/removal structure and the heat source of the electronic device; heating the thermal interface material to an activation temperature to cause the material to soften and conform to opposing surfaces; applying pressure to reduce a bondline thickness and promote displacement of air at an interface; and cooling the thermal interface material to form a stable, thermally conductive interface that resists pump-out during subsequent thermal cycling. The heating and applying pressure cause softening without liquid extrusion. The cooling produces a cohesive interface layer that resists migration under subsequent thermal cycling. And the thermal interface material transitions to the softened conformable state without exhibiting bulk flow and re-solidifies to maintain positional stability and resist pump-out in the absence of a containment structure.

In an exemplary embodiment, an electronic device includes a heat source and a material as disclosed herein that is usable as a thermal interface material (e.g., a phase change thermal interface material, *etc.).* The material is positioned relative to the heat source for establishing at least a portion of a thermally-conductive heat path from the heat source through the material. The material may also be configured to be EMI absorbing and/or electrically conductive, such that the material is also operable for mitigating and/or managing EMI within the electronic device.

In an exemplary embodiment, an electronic device includes a heat source, a heat removal/dissipation structure, and a material as disclosed herein that is usable as a thermal interface material *(e.g.,* a phase change thermal interface material, *etc.).* The material is positioned relative to the heat source and the heat removal/dissipation structure for establishing at least a portion of a thermally-conductive heat path between the heat source and the heat removal/dissipation structure. The material may also be configured to be EMI absorbing and/or electrically conductive, such that the material is also operable for mitigating and/or managing EMI within the electronic device.

In an exemplary embodiment, an electronic device includes a heat source, a board level shield, and a material disclosed herein that is usable as a thermal interface material (e.g., a phase change thermal interface material, *etc.).* The material is positioned relative to the heat source and the board level shield for establishing at least a portion of a thermally-conductive heat path between the heat source and the board level shield. The material may also be configured to be EMI absorbing and/or electrically conductive, such that the material is also operable for mitigating and/or managing EMI within the electronic device.

In an exemplary embodiment, an electronic device includes a heat source, a board level shield, a heat removal/dissipation structure, and first and second materials that are usable as thermal interface materials *(e.g.,* a phase change thermal interface material, *etc.).* The first material is positioned relative to the heat source and the board level shield for establishing at least a portion of a first thermally-conductive heat path between the heat source and the board level shield. The second material is positioned relative to the board level shield and the heat removal/dissipation structure for establishing at least a portion of a second thermally-conductive heat path between the board level shield and the heat removal/dissipation structure. The first and/or second materials may also be configured to be EMI absorbing and/or electrically conductive, such that the first and/or second materials are also operable for mitigating and/or managing EMI within the electronic device.

In an exemplary embodiment, an electronic device includes an integrated circuit, a board level shield, a heat sink, and first and second materials that are usable as thermal interface materials *(e.g.,* a phase change thermal interface material, *etc.).* The first material is positioned relative to the integrated circuit and the board level shield for establishing at least a portion of a first thermally-conductive heat path between the integrated circuit and the board level shield. The second material is positioned relative to the board level shield and the heat sink for establishing at least a portion of a second thermally-conductive heat path between the board level shield and the heat sink. The first and/or second materials may also be configured to be EMI absorbing and/or electrically conductive, such that the first and/or second materials are also operable for mitigating and/or managing EMI within the electronic device.

Exemplary embodiments disclosed herein may provide thermal phase change materials that have a high thermal conductivity of at least 7.5 W/mK, lower burn-in (melt/flow) while maintaining superior resistance to pump-out (e.g., when compared to thermally conductive greases and other phase change materials) and aging. Such exemplary thermal phase change materials may be configured to enhance the cooling of the most rigorous thermal challenges in electronics. With superior wetting of the mating surfaces, the exemplary thermal phase change materials may have a very low (e.g., industry leading lowest, *etc.)* thermal resistance. The exemplary thermal phase change materials may have excellent reliability that is demonstrable through exposure to 2000 hours of various aging tests resulting in proven dependability at an operating temperature of 150°C. The exemplary thermal phase change materials may be configured to provide just the right tack, e.g., remaining on liners yet easily removeable for application.

Exemplary embodiments disclosed herein may provide one or more (but not necessarily any or all of) the following features and benefits: at least 7.5 W/mK bulk thermal conductivity, lower burn-in (melt/flow), low to no pump out, fully characterized long term reliability, non silicone formulation that provides naturally tacky surface, and/or environmentally friendly solution that meets regulatory requirements including RoHS and REACH.

In some embodiments, the thermal interface material is configured to remain substantially in place between opposing thermal surfaces during use, including during repeated thermal cycling and thermomechanical loading. Remaining in place may include resistance to one or more of migration, bleed, pump-out, creep, or lateral displacement of the material from an interface region. Such stability can be maintained despite stresses induced by coefficient of thermal expansion (CTE) mismatch, dynamic warpage of components, and repeated expansion and contraction of mating surfaces. As a result, the material may maintain substantially continuous interfacial coverage and contact across the interface throughout its operational lifetime.

In certain embodiments, the thermal interface material demonstrates resistance to degradation when subjected to accelerated reliability testing conditions representative of electronic device operation. For example, the material can be exposed to thermal cycling or power cycling conditions involving temperature variation between approximately 25°C and approximately 80°C, with cycle durations on the order of about one hour per cycle, and repeated for at least about 2,000 cycles. Such testing may further involve realistic package-level stresses, including die size effects and thermally induced warpage of at least one of the mating structures. Under these conditions, the material may maintain positional stability and resist displacement without the need for mechanical containment structures.

In some embodiments, performance of the thermal interface material under such cycling conditions can be evaluated based on interfacial voiding. The material may exhibit a void fraction of less than about 3% following completion of thermal cycling, and in certain cases within a range of about 1% to about 3%. Void fraction may be determined using known characterization techniques, including but not limited to image-based analysis, optical inspection, or acoustic microscopy techniques such as scanning acoustic microscopy (SAM). Low void formation under these conditions reflects the ability of the material to maintain conformal contact and resist separation from mating surfaces during repeated thermomechanical stress.

Alternatively or additionally, performance may be characterized based on thermal resistance across the interface. In some embodiments, the thermal interface material maintains a substantially constant or stable thermal resistance throughout thermal cycling, such that variation in thermal resistance after completion of testing is less than about 10% relative to an initial value. Thermal resistance measurements may be conducted during or after cycling to confirm that heat transfer performance is substantially preserved despite prolonged exposure to cyclic temperature and mechanical loading.

In further embodiments, the thermal interface material is capable of maintaining the described low-void and stable thermal performance characteristics under testing conditions that simulate real-world application environments, including semiconductor power cycling, processor operation, or other electronic assembly use cases. Such conditions may involve simultaneous application of thermal gradients and mechanical stresses sufficient to induce cyclic warpage in one or both mating components. More broadly, the material may be characterized under any combination of temperature cycling and mechanical deformation that is representative of intended operating environments, and may demonstrate persistent interfacial integrity and thermal performance under such conditions.

Accordingly, the present disclosure relates to thermal interface materials and, more particularly, to thermally conductive phase change materials configured to exhibit low temperature and low pressure activation characteristics while maintaining resistance to pump-out and long-term interfacial stability.

In exemplary embodiments, a thermal interface material is provided comprising a thermally conductive composition including a polymeric matrix and one or more thermally conductive fillers. The material is configured to undergo a phase transition from a dimensionally stable state to a softened, conformable state at a relatively low activation temperature and pressure. For example, the material may be configured to soften and deflect to a minimum bond line thickness and/or minimum thermal resistance at a temperature of about 50°C or less and under a pressure of about 16 psi or less. Upon activation, the material conforms to opposing surfaces of a heat-generating component and a heat dissipation structure, thereby displacing interstitial air and forming a thermally conductive interface.

Following activation, the material is further configured to return to a more structurally stable state and maintain its position between the opposing surfaces. In this state, the material resists migration, bleed, pump-out, creep, or lateral displacement under thermal cycling and operational conditions. The resulting interface provides a stable and consistent thermally conductive pathway over extended use.

In certain embodiments, the thermal interface material is provided as a solid or free-standing preform, such as a sheet or die-cut component, and may exhibit inherent surface tack to facilitate handling and placement. The material may comprise a non-silicone polymeric matrix, including thermoplastic or thermally reversible gel systems, and may be substantially free of silicone components. The material may further be formulated to exhibit high thermal conductivity, for example greater than about 7 W/m·K, along with desirable electrical and mechanical properties.

The present disclosure also provides methods of forming a thermal interface using the disclosed materials. Such methods include positioning the material between a heat-generating component and a heat dissipation structure, and subjecting the material to heat and pressure sufficient to induce softening and conformability. The material thereby forms a low-resistance thermal interface at relatively low activation conditions. Systems and electronic assemblies incorporating the disclosed thermal interface materials are also contemplated.

The thermal interface materials disclosed herein provide a number of advantages over conventional thermal interface materials, including thermal greases, phase change materials, and gap-filling pads. In particular, the disclosed materials achieve a combination of properties that are typically difficult to obtain simultaneously.

The materials provide low-temperature and low-pressure activation, enabling formation of a conformal and low-resistance thermal interface during normal device operation or under mild burn-in conditions, without requiring elevated thermal or mechanical loads. At the same time, the materials exhibit high resistance to pump-out, bleed, and migration. Unlike conventional thermal greases, which may flow or be displaced during thermal cycling, the disclosed materials maintain positional stability and interfacial coverage over extended use. This results in improved long-term reliability and reduced degradation of thermal performance.

The materials further enable the formation of thin bond lines and low interfacial thermal resistance comparable to or better than liquid or grease-based materials, while maintaining the handling and placement advantages of solid preforms. This combination of properties allows improved heat transfer efficiency without sacrificing manufacturability or assembly robustness.

Additionally, the disclosed materials may demonstrate stable performance under repeated thermomechanical stress conditions, including thermal cycling and power cycling involving temperature variations and component warpage. In some embodiments, the materials maintain low interfacial voiding and substantially consistent thermal resistance after extended cycling, thereby ensuring reliable operation in demanding applications.

The use of non-silicone compositions in certain embodiments further provides advantages such as reduced risk of volatility, contamination, or migration associated with silicone-based materials. The materials may also be tailored to provide additional functionalities, such as electrical insulation or electromagnetic interference mitigation.

Accordingly, the present disclosure provides thermal interface materials that overcome limitations of conventional technologies by combining low activation thresholds, high thermal performance, and long-term stability within a single material system.

Exemplary embodiments disclosed herein may be used in a wide range of industries (e.g., aerospace/defense, automotive and industrial electronics, computing, consumer electronics, data infrastructure, industrial electronics, medical equipment, mobile devices, servers, telecommunications, *etc.),* a wide range of applications *(e.g.,* automotive ADAS, automotive electronics, automotive infotainment, avionics, base station/power amplifier/active antenna unit/small cell, graphic cards, drones/satellites, IGBTs, notebooks/tablets/portable devices, *etc.),* and/or with a wide range of capabilities (e.g., automated packaging, automated pad placement, custom automation, custom product development, modeling, prototyping, service, testing, *etc.).* In addition, example embodiments disclosed herein may be used for a wide range of heat sources, electronic devices, and/or heat removal/dissipation structures or components (e.g., a heat spreader, a heat sink, a heat pipe, a vapor chamber, a device exterior case, housing, or chassis, *etc.).* For example, a heat source may comprise one or more heat generating components or devices, such as a high-power integrated circuit (IC), optical transceiver, 5G infrastructure devices *(e.g.,* base stations, small cells, smart poles, *etc.),* solid-state drive (SSD), memory in video cards, set top boxes, televisions, gaming systems, automotive electronics used for autonomous driving (ADAS) *(e.g.,* radars, multi domain controllers, cameras, *etc.),* a CPU, die within underfill, semiconductor device, flip chip device, graphics processing unit (GPU), digital signal processor (DSP), multiprocessor system, integrated circuit (IC), multi-core processor, *etc.*). Generally, a heat source may comprise any component or device that has a higher temperature than a thermal management and/or EMI mitigation material or otherwise provides or transfers heat to the thermal management and/or EMI mitigation material regardless of whether the heat is generated by the heat source or merely transferred through or via the heat source. Accordingly, aspects of the present disclosure should not be limited to use with any single type of heat source, electronic device, heat removal/dissipation structure, *etc.*

Example embodiments are provided so that this disclosure will be thorough and will fully convey the scope to those who are skilled in the art. Numerous specific details are set forth such as examples of specific components, devices, and methods, to provide a thorough understanding of embodiments of the present disclosure. It will be apparent to those skilled in the art that specific details need not be employed, that example embodiments may be embodied in many different forms, and that neither should be construed to limit the scope of the disclosure. In some example embodiments, well-known processes, well-known device structures, and well-known technologies are not described in detail. In addition, advantages and improvements that may be achieved with one or more exemplary embodiments of the present disclosure are provided for purpose of illustration only and do not limit the scope of the present disclosure, as exemplary embodiments disclosed herein may provide all or none of the above mentioned advantages and improvements and still fall within the scope of the present disclosure.

Specific dimensions, specific materials, and/or specific shapes disclosed herein are example in nature and do not limit the scope of the present disclosure. The disclosure herein of particular values and particular ranges of values for given parameters are not exclusive of other values and ranges of values that may be useful in one or more of the examples disclosed herein. Moreover, it is envisioned that any two particular values for a specific parameter stated herein may define the endpoints of a range of values that may be suitable for the given parameter (*i.e.,* the disclosure of a first value and a second value for a given parameter can be interpreted as disclosing that any value between the first and second values could also be employed for the given parameter). For example, if parameter X is exemplified herein to have value A and also exemplified to have value Z, it is envisioned that parameter X may have a range of values from about A to about Z. Similarly, it is envisioned that disclosure of two or more ranges of values for a parameter (whether such ranges are nested, overlapping or distinct) subsume all possible combination of ranges for the value that might be claimed using endpoints of the disclosed ranges. For example, if parameter X is exemplified herein to have values in the range of 1 - 10, or 2 - 9, or 3 - 8, it is also envisioned that parameter X may have other ranges of values including 1 - 9, 1 - 8, 1 - 3, 1 - 2, 2 - 10, 2 - 8, 2 - 3, 3 - 10, and 3 - 9.

The terminology used herein is for the purpose of describing particular example embodiments only and is not intended to be limiting. For example, when permissive phrases, such as "may comprise", "may include", and the like, are used herein, at least one embodiment comprises or includes the feature(s). As used herein, the singular forms "a", "an" and "the" may be intended to include the plural forms as well, unless the context clearly indicates otherwise. The terms "comprises," "comprising," "including," and "having," are inclusive and therefore specify the presence of stated features, integers, steps, operations, elements, and/or components, but do not preclude the presence or addition of one or more other features, integers, steps, operations, elements, components, and/or groups thereof. The method steps, processes, and operations described herein are not to be construed as necessarily requiring their performance of the particular order discussed or illustrated, unless specifically identified as an order of performance. It is also to be understood that additional or alternative steps may be employed.

When an element or layer is referred to as being "on", "engaged to", "connected to" or "coupled to" another element or layer, it may be directly on, engaged, connected or coupled to the other element or layer, or intervening elements or layers may be present. In contrast, when an element is referred to as being "directly on," "directly engaged to", "directly connected to" or "directly coupled to" another element or layer, there may be no intervening elements or layers present. Other words used to describe the relationship between elements should be interpreted in a like fashion (e.g., "between" versus "directly between," "adjacent" versus "directly adjacent," *etc.).* As used herein, the term "and/or" includes any and all combinations of one or more of the associated listed items.

The term "about" when applied to values indicates that the calculation or the measurement allows some slight imprecision in the value (with some approach to exactness in the value; approximately or reasonably close to the value; nearly). If, for some reason, the imprecision provided by "about" is not otherwise understood in the art with this ordinary meaning, then "about" as used herein indicates at least variations that may arise from ordinary methods of measuring or using such parameters. For example, the terms "generally", "about", and "substantially" may be used herein to mean within manufacturing tolerances. Or for example, the term "about" as used herein when modifying a quantity of an ingredient or reactant of the invention or employed refers to variation in the numerical quantity that can happen through typical measuring and handling procedures used, for example, when making concentrates or solutions in the real world through inadvertent error in these procedures; through differences in the manufacture, source, or purity of the ingredients employed to make the compositions or carry out the methods; and the like. The term "about" also encompasses amounts that differ due to different equilibrium conditions for a composition resulting from a particular initial mixture. Whether or not modified by the term "about", equivalents to the quantities are included.

Although the terms first, second, third, *etc.* may be used herein to describe various elements, components, regions, layers and/or sections, these elements, components, regions, layers and/or sections should not be limited by these terms. These terms may be only used to distinguish one element, component, region, layer or section from another region, layer or section. Terms such as "first," "second," and other numerical terms when used herein do not imply a sequence or order unless clearly indicated by the context. Thus, a first element, component, region, layer or section discussed below could be termed a second element, component, region, layer or section without departing from the teachings of the example embodiments.

Spatially relative terms, such as "inner," "outer," "beneath", "below", "lower", "above", "upper" and the like, may be used herein for ease of description to describe one element or feature's relationship to another element(s) or feature(s) as illustrated in the figures. Spatially relative terms may be intended to encompass different orientations of the device in use or operation in addition to the orientation depicted in the figures. For example, if the device in the figures is turned over, elements described as "below" or "beneath" other elements or features would then be oriented "above" the other elements or features. Thus, the example term "below" can encompass both an orientation of above and below. The device may be otherwise oriented (rotated 90 degrees or at other orientations) and the spatially relative descriptors used herein interpreted accordingly.

The foregoing description of the embodiments has been provided for purposes of illustration and description. It is not intended to be exhaustive or to limit the disclosure. Individual elements, intended or stated uses, or features of a particular embodiment are generally not limited to that particular embodiment, but, where applicable, are interchangeable and can be used in a selected embodiment, even if not specifically shown or described. The same may also be varied in many ways. Such variations are not to be regarded as a departure from the disclosure, and all such modifications are intended to be included within the scope of the disclosure.

## Claims

1. A method comprising using a thermal interface material for establishing a thermal joint for conducting heat between a heat dissipating/removal structure and a heat source of an electronic device, wherein the thermal interface material is configured to have a low temperature and low pressure burn-in that enables the thermal interface material to soften and deflect to its thinnest bond line and/or minimum thermal resistance at a minimal temperature of about 50 degrees Celsius (°C) or less while under a minimal pressure of 16 pounds per square inch (PSI) or less.

2. The method of claim 1, wherein the method includes heating the thermal interface material to the minimal temperature of about 50 °C or less while under the minimal pressure of 16 PSI or less such that:
the thermal interface material softens and deflects to its thinnest bond line of about 25 microns between the heat dissipating/removal structure and the heat source of the electronic device; and/or
the thermal interface material softens and deflects to its minimum thermal resistance whereby additional heating/pressure will not further decrease the thermal resistance of the thermal interface material.

3. The method of any one of the preceding claims, wherein:
the thermal interface material is a thermal phase change material, and the method includes applying heat and pressure to the thermal phase change material to induce a phase change and causing the thermal phase change material to conform to opposing surfaces and reduce interfacial thermal resistance;
the heat and pressure comprise a burn-in process sufficient to soften the thermal phase change material and improve wetting; and
the thermal phase change material forms a bondline thickness of less than about 50 microns after the phase change.

4. The method of any one of the preceding claims, wherein the method includes heating the thermal interface material to the minimal temperature of about 50 °C or less while under the minimal pressure of 16 PSI such that the thermal interface material softens and deflects from an initial thickness within a range from about 125 microns to about 400 microns down to a bond line thickness of about 25 microns between the heat dissipating/removal structure and the heat source of the electronic device.

5. The method of any one of the preceding claims, wherein the method includes operating the electronic device to thereby heat the thermal interface material to the minimal temperature of about 50 °C or less while under the minimal pressure of 16 PSI or less between the heat dissipating/removal structure and the heat source of the electronic device.

6. The method of any one of the preceding claims, wherein the thermal interface material comprises a thermal phase change material configured such that:
an initial operation of the heat source within its normal operating temperature range heats the thermal phase change material to the minimal temperature of about 50 °C or less while under the minimal pressure of 16 PSI or less whereby the thermal phase change material softens and deflects to its thinnest bond line and/or minimum thermal resistance between the heat dissipating/removal structure and the heat source to thereby establish the thermal joint for conducting heat between the heat dissipating/removal structure and the heat source; and
the thermal phase change material is configured to return to its original state and remain in its original state after forming the thinnest bond line and/or minimum thermal resistance between the heat source and the heat dissipating/removal structure, whereby the thermal phase change material is operable to preclude the heat source from heating beyond its normal operating temperature range during operation of the electronic device and heat is flowable through the thermal joint from the heat source during operation of the electronic device whereby temperature of the heat source is reduced.

7. The method of any one of the preceding claims, wherein the method comprises:
positioning a solid phase change thermal interface material between the heat dissipating/removal structure and the heat source of the electronic device;
heating the thermal interface material to an activation temperature to cause the material to soften and conform to opposing surfaces;
applying pressure to reduce a bondline thickness and promote displacement of air at an interface; and
cooling the thermal interface material to form a stable, thermally conductive interface that resists pump-out during subsequent thermal cycling;
wherein the heating and applying pressure cause softening without liquid extrusion;
wherein the cooling produces a cohesive interface layer that resists migration under subsequent thermal cycling; and
wherein the thermal interface material transitions to the softened conformable state without exhibiting bulk flow and re-solidifies to maintain positional stability and resist pump-out in the absence of a containment structure.

8. The method of any one of the preceding claims, wherein:
the thermal interface material has a thermal conductivity within a range from about 7 Watts per meter per Kelvin (W/mK) to about 9 W/mK as determined by Hot Disk Thermal Constants Analyzer;
the thermal interface material has a hardness of about 93 Shore 00 or less at room temperature or a temperature of about 25 °C;
the thermal interface material comprises at least one filler in a matrix including di-block copolymer and processing oil;
the thermal interface material is entirely free of tri-block copolymer or does not include any detectable tri-block copolymer; and/or
the thermal material is entirely free of silicone or does not include any detectable silicone.

9. The method of any one of the preceding claims, wherein the thermal interface material is configured to have an inverse tan delta of at least 1.75 within a temperature range from about 25 °C to about 150 °C.

10. A material useful for the management of heat and/or electromagnetic interference (EMI), the material comprising at least one filler in a matrix, wherein the material is configured to have a low temperature and low pressure burn-in that enables the material to soften and deflect to its thinnest bond line and/or minimum thermal resistance at a minimal temperature of about 50 degrees Celsius (°C) or less while under a minimal pressure of 16 pounds per square inch (PSI) or less.

11. The material of claim 10, wherein:
the material is configured to soften and deflect to its minimum thermal resistance when heated to the minimal temperature of about 50 °C or less while under the minimal pressure of 16 PSI or less such that additional heating/pressure will not further decrease the thermal resistance of the material; and/or
the material is configured to soften and deflect to its thinnest bond line of about 25 microns when heated to the minimal temperature of about 50 °C or less while under the minimal pressure of 16 PSI or less.

12. The material of claim 10 or 11, wherein:
the material comprises a thermal interface material for establishing a thermal joint for conducting heat between a heat dissipating/removal structure and a heat source of an electronic device; and/or
the material is configured to soften and deflect to its thinnest bond line and/or minimum thermal resistance when heated to the minimal temperature of about 50 °C or less while under a minimal pressure from about 5 PSI to 10 PSI.

13. The material of any one of claims 10 to 12, wherein:
the material comprises at least one filler in a matrix including di-block copolymer and processing oil;
the material is entirely free of tri-block copolymer and/or t does not include any detectable tri-block copolymer;
the material is entirely free of silicone and/or the material does not include any detectable silicone;
the material has a thermal conductivity within a range from about 7 Watts per meter per Kelvin (W/mK) to about 9 W/mK as determined by Hot Disk Thermal Constants Analyzer; or
the material has a hardness of about 93 Shore 00 or less at room temperature or a temperature of about 25 °C.

14. The material of any one of claims 10 to 13, wherein:
the material comprises a solid, free-standing phase change composition including a thermally conductive filler dispersed within a non-silicone polymeric matrix;
the material exhibits a bulk thermal conductivity of at least about 7 W/m·K;
the composition is configured to:
transition from a first, dimensionally stable state to a softened conformable state in response to elevated temperature;
wet opposing surfaces of a heat-generating component and a heat dissipation structure during the softened state to displace interfacial air; and
re-establish a mechanically stable interface upon cooling;
the material provides a thermally conductive pathway and resists migration or pump-out under thermal cycling; and
the material transitions to the softened conformable state without exhibiting bulk flow and re-solidifies to maintain positional stability and resist pump-out in the absence of a containment structure.

15. The material of any one of claims 10 to 14, wherein
the material complies with flammability standards corresponding to a V0 UL94 rating;
the material is configured to remain substantially in place between mating surfaces without migration during thermal cycling thereby substantially preventing at least one of pump-out, bleed, creep, or lateral displacement of the material;
the material is configured to exhibit less than about 3% interfacial voiding following repeated power cycling between a lower temperature of about 25°C and an upper temperature of about 80°C with cycle durations of approximately one hour and at least about 2,000 cycles; and
the material is configured to have an inverse tan delta of at least 1.75 within a temperature range from about 25 °C to about 150 °C.
